# EUROPEAN PATENT APPLICATION

(11) **EP 1 584 871 A2**
(43) Date of publication of application: **12.10.2005**
(21) Application number: 05252128.3
(22) Date of filing: 05.04.2005
(51) Int. Cl.: F23R 3/00, F23M 5/00, C30B 11/00

(54) **Single crystal articles having controlled crystallographic orientation**

(30) Priority: 08.04.2004 US 821091
(71) Applicant: UNITED TECHNOLOGIES CORPORATION, Hartford, Connecticut 06101 (US)
(72) Inventor: Schlichting, Kevin W., Storrs CT 06268 (US); Murray, Stephen D., Marlborough CT 06447 (US); Cetel, Alan D., West Hartford CT 06117 (US); Marcin, John J. Jr., Marlborough CT 06108 (US)
(74) Representative: Hall, Matthew Benjamin

(57) **Abstract**

An article has a characteristic thermal-mechanical stress principal direction. The article has a single crystal substrate having a lowest modulus direction within a target alignment with the principal direction.

## Description

The invention relates to combustors casting. More particularly, the invention relates to casting of combustor panels for gas turbine engines.

Gas turbine engine combustor components such as heat shield and floatwall panels are commonly made of polycrystalline alloys. These components are exposed to extreme heat and thermal gradients during various phases of engine operation. Thermal-mechanical stresses and resulting fatigue contribute to component failure. Significant efforts are made to cool such components to provide durability.

Nevertheless, there remains need for improvement in component durability.

One aspect of the invention involves a gas turbine engine combustor component. The component has: a characteristic thermal mechanical stress principal direction; and a single crystal substrate having a lowest modulus direction within 15° of said principal direction.

In various implementations, the component may be selected from the group consisting of: combustor shell pieces; and heat shields pieces. The component may have an overall shape of a frustoconical shell segment. A gas turbine engine may include a plurality of such components used as heat shield pieces. The component may further comprise at least a partial coating on the substrate. The crystalline structure may be face-centered cubic. The crystalline structure may consist essentially of a nickel-based superalloy. The nickel-based superalloy may have 1.0-12.0 Cr, 5.0-20.0 Co, 4.0-10.0 Ta, 5.3-6.5 Al, and 5.5-10.0 W, by weight, and a gamma prime (γ') volume fraction in excess of 50%.

Another aspect of the invention involves a combustor panel characterized by: a substrate having an overall shape of a frustoconical segment; and a single crystal grain structure of the substrate having a lowest modulus first direction within 30° of a central characteristic direction. The characteristic direction is a circumferential direction if the panel has a cone half angle less than 45° in magnitude or a conewise direction if greater than 45°.

In various implementations, the lowest modulus first direction may be within 15° of said central characteristic circumferential direction. A lowest or second lowest modulus second direction may be within 30° of a central characteristic surface longitudinal direction. The panel may be used in a gas turbine engine. The panel may have a cone half angle of -30° to 30°. The cone half angle may be +/-(5° to 30°). substrate may consist essentially of a nickel based superalloy. The panel may have first and second edges essentially extending circumferentially and third and fourth edges essentially extending in longitudinal/radial planes. The panel may have a characteristic circumferential span of 20° to 60°. The panel may have a longitudinal span of 30mm to 200mm.

Another aspect of the invention involves a method for engineering a combustor component subject to thermal mechanical fatigue. A characteristic thermal mechanical stress principal direction is determined. The component is fabricated so as to comprise a single crystal substrate having a lowest modulus direction within a target alignment with said principal direction.

In various implementations, the target alignment is to within 15° of said principal direction. The determining may comprise a simulation. The method may be used to reengineer a replacement for an original component. The replacement may have an elastic modulus in said principal direction of less than twenty Msi (138 GPa). The original component may have an elastic modulus in said principal direction of greater than thirty Msi (207 GPa). A thermal-mechanical stress secondary direction may be determined. The fabricating may provide the substrate with a second direction, also being a lowest modulus direction. At least a partial coating may be applied to the substrate.

Other features, objects, and advantages of the invention will be apparent from the description and drawings, and from the claims.

Preferred embodiments of the present invention will now be described by way of example only and with reference to the accompanying drawings in which:
FIG. 1 is a longitudinal sectional view of a gas turbine engine combustor.
FIG. 2 is a view of an inboard heat shield panel of the combustor of FIG. 1.
FIG. 3 is a view of an outboard heat shield panel of the combustor of FIG. 1.
FIG. 4 is an aft view of a bulkhead heatshield panel.
FIG. 5 is a side view of the panel of FIG. 4.
FIG. 6 is a view of crystallographic axes of a face-centered cubic structure.

Like reference numbers and designations in the various drawings indicate like elements.

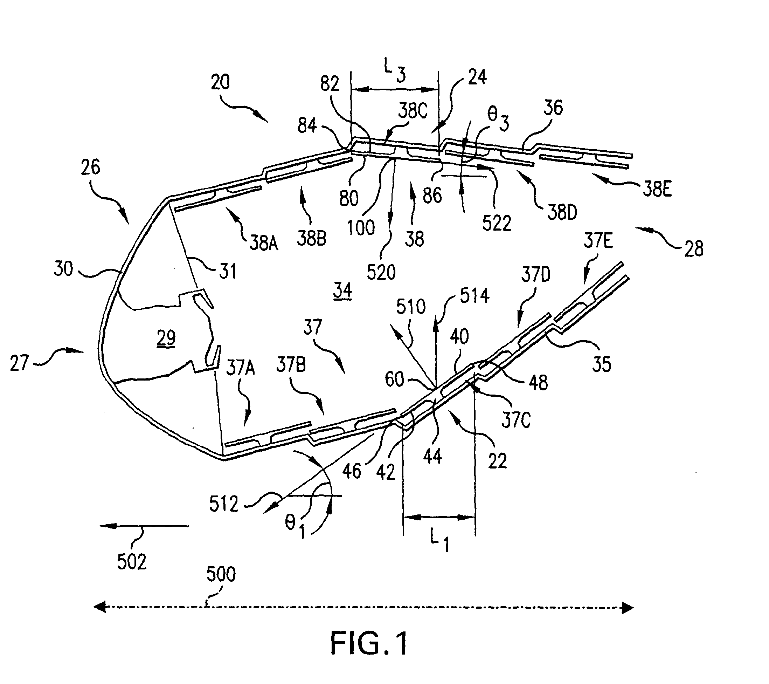

FIG. 1 shows a gas turbine engine combustor 20. The exemplary combustor 20 is generally annular about an engine central longitudinal axis (centerline) 500 parallel to which a forward direction 502 is illustrated. The exemplary combustor has two-layered inboard and outboard walls 22 and 24. The walls 22 and 24 extend aft/downstream from a bulkhead 26 at an upstream inlet 27 receiving air from the compressor section (not shown) to a downstream outlet 28 delivering air to the turbine section (not shown). A circumferential array of fuel injector/swirler assemblies 29 may be mounted in the bulkhead.

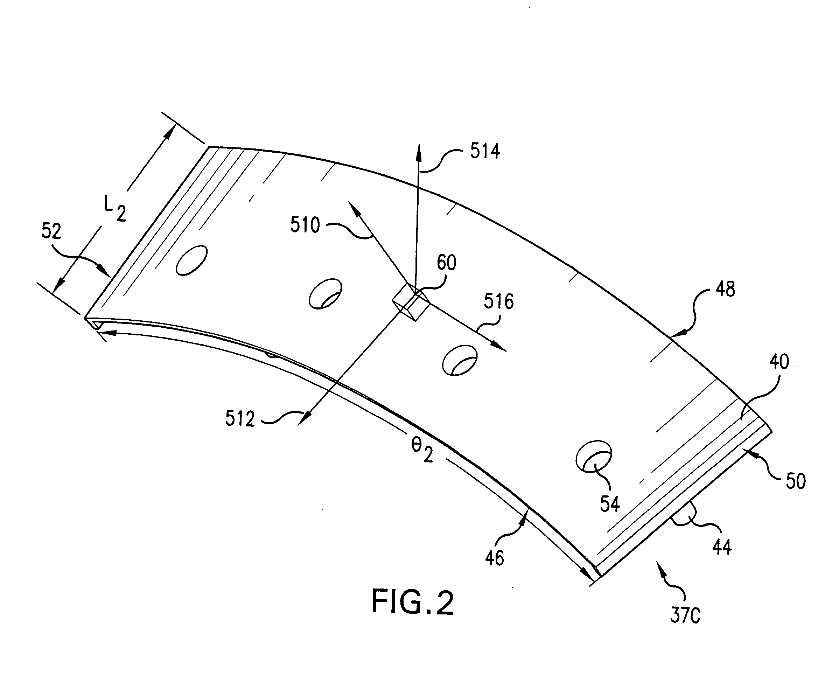

The bulkhead includes a shell portion 30 and a heat shield 31 spaced aft/downstream thereof. The heat shield 31 may be formed by a circumferential array of bulkhead panels, at least some of which have apertures for accommodating associated ones of the injector/swirler assemblies. The combustor has an interior 34 aft/downstream of the bulkhead panel array. The inboard and outboard walls 22 and 24 respectively have an outboard shell 35 and 36 and an inner heat shield 37 and 38. The shells may be contiguous with the bulkhead shell. Each exemplary wall heat shield is made of a longitudinal and circumferential array of panels as may be the shells. In exemplary combustors there are two to six longitudinal rings of six to twenty heat shield panels. From upstream to downstream, respective panels of the shields 37 and 38 are identified as 37A-E and 38A-E. With reference to the exemplary panel 37C, each panel has a generally inner (facing the interior 34) surface 40 and a generally outer surface 42. Mounting studs 44 or other features may extend from the other surface 42 to secure the panel to the adjacent shell. The panel extends between a leading edge 46 and a trailing edge 48 and between first and second lateral (circumferential) edges 50 and 52 (FIG. 2). The panel may have one or more arrays of cooling holes 54 between the inner and outer surfaces and may have additional surface enhancements (not shown) on one or both of such surfaces as is known in the art or may be further developed.

The inner surface 40 is circumferentially convex and has a center 60. FIG. 1 further shows a surface normal 510 and a conewise direction 512 normal thereto. The exemplary panel has a conical half angle θ₁, a longitudinal span L₁, and a conewise span L₂ (FIG. 2). A radial direction is shown as 514. A circumferential direction is shown as 516. An angle spanned by the panel between the lateral edges about the engine centerline is shown as θ₂. With an exemplary eight panels per ring, θ₂ is nominally 45° (e.g., slightly smaller to provide gaps between panels).

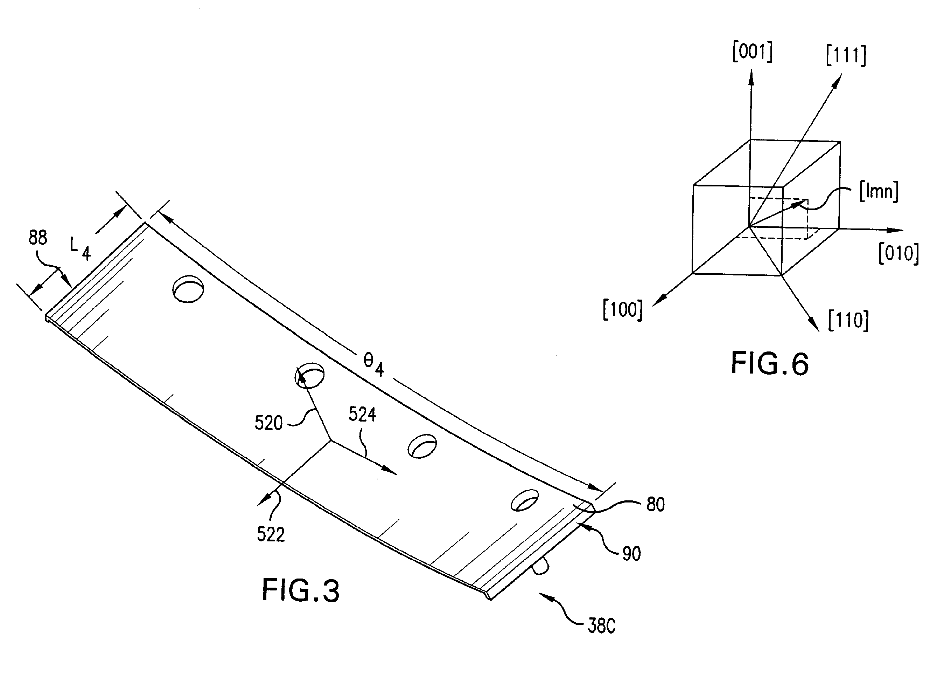

Similarly, the exemplary panel 38C has inner and outer surfaces 80 and 82, leading and trailing edges 84 and 86, and lateral edges 88 and 90 (FIG. 2). The inner surface 80 is circumferentially concave and has a center 100. A surface normal is shown as 520 and a conewise direction shown as 522. The conical half angle is shown as -θ₃ (for reference, a negative angle will be associated with a rearwardly convergent cone) and the longitudinal span is shown as L₃. A circumferential direction is shown as 524 in FIG. 3. A circumferential span is shown as θ₄ and the conewise span is shown as L₄.

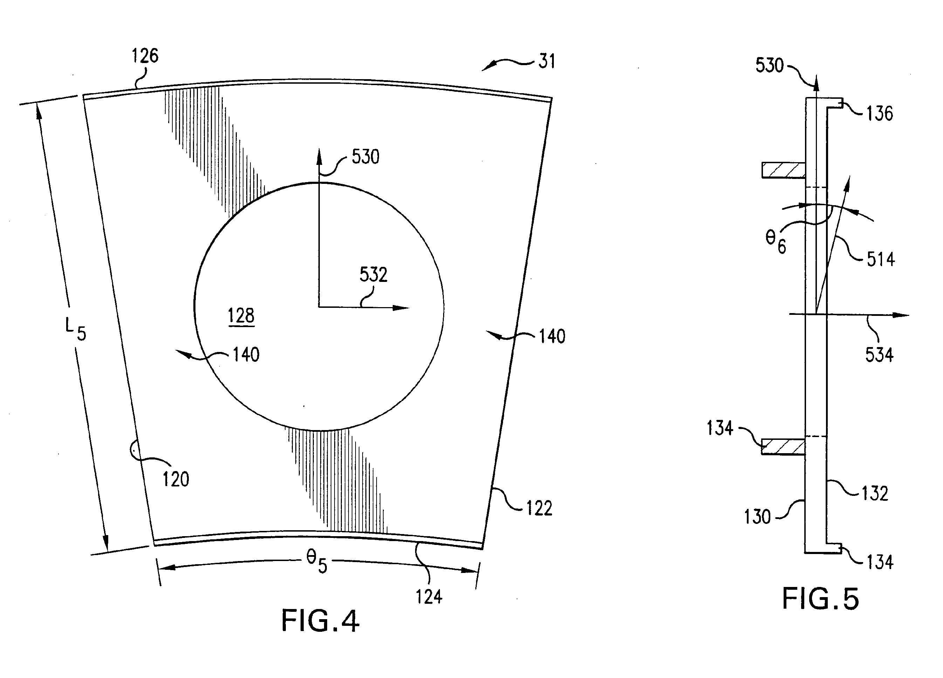

FIG. 4 shows the bulkhead heatshield panel 31 formed as an annular segment of angular span θ₅ between radially-extending circumferential edges 120 and 122 and extending along a radial span L₅ between inboard and outboard edges 124 and 126. The exemplary panel 31 has a central aperture 128 for accommodating an associated one of the injector/swirler assemblies. The aperture 128 extends between fore and aft surfaces 130 and 132 (FIG. 5). Mounting studs 134 extend forward from the fore surface 130. Inboard and outboard rims 134 and 136 extend aft from the aft surface 132. The panel may extend radially or may be at an off-radial angle θ₆. A central conewise direction is shown as 530. A circumferential direction is shown as 532, and a central surface normal direction is shown as 534 (FIG. 5). The last direction is treated as a characteristic surface normal even though it occurs at the aperture 128. High stress areas 140 have been observed at either circumferential side of the aperture 128. The stresses may cause generally circumferential cracks at these locations between the aperture and the adjacent edges 120 and 122.

Typical prior art panels are formed of polycrystalline nickel-based superalloys having elastic modulus in the vicinity of 30-40 Msi. Advanced single crystal alloys have been developed for use in gas turbine engine blades and may be applied to the present panels as described further below. Such superalloys are especially adapted for high temperature (650C+) service. Single crystal articles may, however, be made from various superalloys previously used in equiaxed and columnar grain castings or subsequently developed. Exemplary nickel-based superalloys are described in U.S. Pat. Nos. 4,116,723 and 4,209,348 to Duhl et al. Generally, these high gamma prime (γ') superalloys have higher operating temperatures than equiaxed alloys. Nonetheless, it will be appreciated that the invention may be useful not only with nickel alloys, but with face centered cubic structure alloys of cobalt, iron and other metals and with metals having other crystal structures.

In particularly hot conditions (e.g., desert operation) these panels were often observed to suffer cracking due to thermal-mechanical fatigue (TMF) resulting from thermal-mechanical stresses. For relatively longitudinal panels (e.g., 37A-E and 38A-E with θ₁ and θ₃ magnitudes less than 45°, and more narrowly less than 40° or 30°) it has been observed that the high (primary) stress orientation is essentially the circumferential direction. Additionally, the secondary stress direction has been observed as essentially the conewise direction. For relatively radial panels (e.g., bulkhead panel 31 with θ₆ magnitude less than 30°) the primary stress direction is essentially the conewise direction 530 and the secondary stress direction is essentially the circumferential direction 532.

Forming the panels from a single crystal alloy having a low modulus direction aligned with the high stress direction may potentially alleviate cracking. FIG. 4 shows the conventional Miller indices for an octal unit cell of a face-centered cubic (fcc) crystal characteristic of nickel and certain other metal systems such as aluminum, copper, etc. In the cubic system, specification of the orientation in space of any two orthogonal axes, such as [100] and [001], will fully define the orientation of a crystal.

Properties vary with orientation in a fcc crystal. Referring to FIG. 6, the [001], [010], and [001] axes are characterized by the same properties and are all lowest modulus. Other crystal systems may lack three equivalent lowest modulus axes. Lying in the plane of the [100] and [010] axes is the [110] axis at a 45° angle to the [100] axis. According to the present teachings, an article such as the panels has a lowest modulus axis (e.g., the [001]) aligned with the primary stress direction 516;524;532 (i.e., parallel thereto or within a tolerance as described below). Manufacturing and other considerations may make exact alignment difficult to achieve with a desired repeatability. Thus a tolerance may be established that the alignment be within a first target angle (e.g., 15°). Additionally, a second lowest modulus axis (e.g., for the fcc structure another of the lowest modulus axes) is advantageously aligned with the secondary stress direction 512;522;530. The lower stresses associated with the secondary stress direction may permit a broader range of target alignment with such direction while still providing a desires resistance to failure. Thus an exemplary second target angle for the secondary stress alignment may be broader than the first target angle (e.g., 30° vs. 15°). The relative magnitudes of the stresses in the primary and secondary stress directions may thus influence the relative permissible or desired ranges of target alignments. Thus broader first and second alignments would be to within 20° and 35° and narrower first and second alignments would be to within 10° and 20°.

An exemplary weight % specification for one particular subgroup of nickel-based superalloys useful in the present invention is: 1.0-12.0 Cr; 5.0-20.0 Co; 0.0-1.0 Ti; 5.3-6.5 Al; 5.5-10.0 W; 0-0.1 Y; 0.5-2.5 Mo; 0.0-7.0 Re; 0.0-5.0 Ru; 4.0-10.0 Ta; and 0.0-0.5 Hf, with a gamma prime (γ') volume fraction in excess of 50%. The balance may be nickel and impurities. A narrower specification for a particular alloy in that subgroup is: 4.0-6.0 Cr; 9.0-11.0 Co; 0.0-1.0 Ti; 5.3-6.0 Al; 5.5-6.5 W; 0.001-0.1 Y; 1.5-2.5 Mo; 2.5-3.5 Re; 8.0-9.0 Ta; and 0.05-0.45 Hf, with a gamma prime (γ') volume fraction in excess of 55%. Additional components may advantageously be at no more than impurity levels for these specific alloys.

The invention may be applied to the engineering or reengineering of a component. An exemplary reengineering of a combustor panel starts with a baseline panel having a baseline physical configuration and formed of a baseline polycrystalline material having an exemplary elastic modulus of thirty Msi (207 GPa) to forty Msi (276 GPa). The exemplary reengineering may preserve the physical configuration or may include changes thereto. A characteristic thermal-mechanical stress primary direction is determined. A characteristic thermal-mechanical stress secondary direction is determined. This may be done analytically (e.g., in a computational or other simulation) or physically (e.g., by measurements on a sample or physical model subject to actual thermal-mechanical stress). The characteristic directions may be spatial (e.g., volumetric) averages, optionally weighted. The characteristic directions may be directions of peak stress at locations of peak stress. For the exemplary frustoconical segment, the characteristic directions may largely be independent of the measurement technique. The characteristic stress may be identified at the center of the panel.

The panel is fabricated so as to comprise a single crystal substrate having a lowest modulus direction within the first target alignment with said primary direction and a second lowest modulus direction within the second target alignment with said second direction. The lowest modulus may be less than twenty Msi (138 GPa) (e.g., about eighteen Msi (124 GPa). Even with perfect alignment at the panel center (or other characteristic location), there may be misalignment elsewhere. For example, with circumferential panel segments, if the primary stress direction is circumferential essentially everywhere then the alignment will vary circumferentially along the panel up to the half angle of the panel. Nevertheless, it is advantageous that some target alignment be obtained at the peak stress locations and over some volume fraction (optionally stress-weighted) of the panel.

The panels may be made by a casting process (e.g., investment casting). To achieve the desired relative alignments of crystal and stress axes, a seed (not shown) may be located in a grain starter section of the casting shell (not shown) as is known in the art. Additional techniques may be developed. Post-casting machining and chemical, thermal and/or mechanical treatments may be appropriate as are coatings (e.g., ceramics) applied to the single crystal cast substrate. A variety of such treatments and coatings are known in the art and others may be developed.

One or more embodiments of the present invention have been described. Nevertheless, it will be understood that various modifications may be made without departing from the spirit and scope of the invention. For example, and applied as a reengineering of an existing component, details of the existing component may influence or dictate details of any particular implementation. Accordingly, other embodiments are within the scope of the following claims.

## Claims

1. A gas turbine engine combustor component comprising:
a characteristic thermal-mechanical stress principal direction; and
a single crystal substrate having a lowest modulus direction within 15° of said principal direction.

2. The component of claim 1 or 2 used as a gas turbine engine component selected from the group consisting of:
combustor shell pieces; and
combustor heat shield pieces.

3. The component of claim 1 having an overall shape of a frustoconical shell segment.

4. A gas turbine engine including a plurality of components according to claim 3 used as combustor heat shield pieces.

5. The component of claim 1, 2 or 3 further comprising
at least a partial coating on the substrate.

6. The component of claim 1, 2, 3 or 5 wherein:
said crystalline structure is face-centered cubic.

7. The component of any of claims 1, 2, 3, 5 or 6 wherein:
said crystalline structure consists essentially of a nickel-based superalloy.

8. The component of claim 7 wherein said nickel-based superalloy has, by weight percent:
1.0-12.0 Cr;
5.0-20.0 Co;
4.0-10.0 Ta;
5.3-6.5 Al; and
5.5-10.0 W; and
a gamma prime (γ') volume fraction in excess of 50%.

9. A combustor panel **characterized by**:
a substrate having an overall shape of a frustoconical segment; and
a single crystal grain structure of the substrate having a lowest modulus first direction within 30° of:
a central characteristic circumferential direction if a cone half angle of the panel has a magnitude less than 45°; or
a central characteristic conewise direction if the cone half angle of the panel has a magnitude greater than 45°.

10. The panel of claim 9 further **characterized by**:
said lowest modulus first direction being within 15° of said central characteristic circumferential direction; and
a lowest or second lowest modulus second direction within 30° of a central characteristic surface longitudinal direction.

11. The panel of claim 9 or 10 used in a gas turbine engine.

12. The panel of claim 9, 10 or 11 further **characterized by**:
the cone half angle being -30° to 30°.

13. The panel of any of claims 9 to 12 further **characterized by**:
the cone half angle being +/-(5° to 30°).

14. The panel of claim 9, 10 or 11 further **characterized by**:
the cone half angle having a magnitude in excess of 60°; and
the panel having a swirler aperture having a linear dimension of at least 25% of at least one of a local circumferential or local radial span.

15. The panel of any of claims 9 to 14 wherein:
the substrate consists essentially of a nickel-based superalloy

16. The panel of any of claims 9 to 15 further **characterized by**:
first and second edges essentially extending circumferentially; and
third and fourth edges essentially extending in longitudinal/radial planes.

17. The panel of any of claims 9 to 16 further **characterized by**:
a characteristic circumferential span of 20° to 60°.

18. The panel of any of claims 9 to 17 further **characterized by**:
a longitudinal span of 30mm to 200mm.

19. A method for engineering combustor component subject to thermal-mechanical fatigue comprising:
determining a characteristic thermal-mechanical stress principal direction; and
fabricating the component so as to comprise a single crystal substrate having a lowest modulus direction within a target alignment with said principal direction.

20. The method of claim 19 or 20 wherein:
said target alignment is within 15° of said principal direction.

21. The method of claim 19 or 20 wherein:
the determining comprises a simulation.

22. The method of claim 19, 20 or 21 used to reengineer a replacement for an original component.

23. The method of claim 22 wherein:
the replacement has an elastic modulus in said principal direction of less than twenty Msi (138 GPa); and
the original article has an elastic modulus in said principal direction of greater than thirty Msi (207 GPa).

24. The method of any of claims 19 to 23 further comprising determining a thermal-mechanical stress secondary direction and wherein said fabricating provides said substrate with a second direction, also being a lowest modulus direction.

25. The method of any of claims 19 to 24 further comprising:
applying at least a partial coating to the substrate.
